(19) Europäisches Patentamt
European Patent Office
Office européen des brevets

(11) EP 0 652 489 B1

(12) **EUROPEAN PATENT SPECIFICATION**

(45) Date of publication and mention of the grant of the patent:
**05.11.1997 Bulletin 1997/45**

(51) Int Cl.⁶: **G03F 7/40**, G03F 7/075

(21) Application number: **94112431.5**

(22) Date of filing: **09.08.1994**

(54) **Process for processing a photosensitive lithographic printing plate requiring no fountain solution**

Verfahren zum Behandeln einer Flachdruckplatte, die kein Feuchtwasser erfordert

Procédé pour le traitement d'une plaque lithographique pour l'impression à sec

(84) Designated Contracting States:
**DE GB**

(30) Priority: **12.08.1993 JP 200750/93**

(43) Date of publication of application:
**10.05.1995 Bulletin 1995/19**

(73) Proprietor: **FUJI PHOTO FILM CO., LTD.**
**Kanagawa (JP)**

(72) Inventors:
- **Urabe, Yoshihiko, c/o Fuji Photo Film Co., Ltd.**
  **Haibara-gun, Shizuoka (JP)**
- **Yoshida, Susumu, c/o Fuji Photo Film Co., Ltd.**
  **Haibara-gun, Shizuoka (JP)**
- **Tanaka, Yuzi, c/o Fuji Photo Film Co. Ltd.**
  **Haibara-gun, Shizuoka (JP)**
- **Hirano, Tsumoru, c/o Fuji Photo Film Co., Ltd.**
  **Haibara-gun, Shizuoka (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 510 646** **DE-A- 4 232 673**

- **DATABASE WPI Week 9221, Derwent Publications Ltd., London, GB; AN 92-170342 & JP-A-4 098 261 (KONICA CORP.) 30 March 1992**
- **DATABASE WPI Week 9249, Derwent Publications Ltd., London, GB; AN 92-405054 & JP-A-4 304 458 (KONICA CORP.) 27 October 1992**
- **DATABASE WPI Week 9223, Derwent Publications Ltd., London, GB; AN 92-188760 & JP-A-4 122 933 (KONICA CORP.) 23 April 1992**
- **DATABASE WPI Week 9301, Derwent Publications Ltd., London, GB; AN 93-005194 & JP-A-4 333 851 (20.11.92)**

Remarks:
The file contains technical information submitted after the application was filed and not included in this specification

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 652 489 B1

## Description

### FIELD OF THE INVENTION

The present invention relates to a process for processing a photosensitive lithographic printing plate requiring no fountain solution comprising a photosensitive layer and a silicone rubber layer laminated on a support in this order and more particularly to a process for processing the photosensitive lithographic printing plate requiring no fountain solution which provides improvements in the scratch resistance and press life of the silicone rubber layer.

### BACKGROUND OF THE INVENTION

Various photosensitive lithographic printing plates requiring no fountain solution (hereinafter referred to as "water-free lithographic printing plate") for lithographic printing without fountain solution have been proposed. Among them, those comprising a photosensitive layer and a silicone rubber layer coated on a support in this order as disclosed in JP-B-54-26923 (The term "JP-B" as used herein means an "examined Japanese patent publication"), JP-B-55-22781, JP-B-56-23150, and JP-A-2-236550 (The term "JP-A" as used herein means an "unexamined published Japanese patent application") have extremely high performances.

As a process for the development of such a water-free lithographic printing plate there is disclosed a process which comprises the use of a hydrocarbonic organic solvent which swells only a silicone rubber layer or a hydrocarbonic organic solvent with a polar solvent added thereto in JP-B-56-23150, JP-A-57-13448, JP-A-59-146054, and JP-A-63-52145. However, this process requires a long development time. In order to obtain fine halftone dots on the highlight with a good reproducibility, it is necessary that the printing plate be brushed to a certain extent. Accordingly, this process is disadvantageous in that even the silicone rubber layer to be left as non-image area can be damaged. On the other hand, JP-B-63-46407 discloses a process which comprises eluting a part or whole of the photosensitive layer on the image area with a processing solution capable of dissolving at least a part of the photosensitive layer on the image area, and then rubbing the printing plate in the presence of water or a solvent mainly composed of water which doesn't swell the silicone rubber layer to peel off the silicone rubber layer. Further, JP-A-1-159644 and JP-A-3-231752 disclose a developer comprising water as a main component. These approaches can provide drastic reduction of damage of the silicone rubber layer on the non-image area during development but leave much to be desired in the prevention of damage on the silicone rubber layer in handling and printing after processing.

### SUMMARY OF THE INVENTION

It is therefore a first object of the present invention to provide a processing method for obtaining a water-free lithographic printing plate having an excellent scratch resistance. It is a second object of the present invention to provide processing method for obtaining a water-free lithographic printing plate having an excellent press life.

The objects of the present invention are accomplished by a process for processing a photosensitive lithographic printing plate requiring no fountain solution comprising a photosensitive layer and a silicone rubber layer laminated on a support in this order, said process comprising the steps of:

(a) imagewise exposing said lithographic printing plate;

(b) developing the exposed lithographic printing plate with an aqueous developer capable of peeling off substantially only the silicone rubber layer on the unexposed area; and then

(c) dyeing the exposed image area with a dye solution comprising at least one sparingly water-soluble compound and at least one hydrotrope agent, wherein the sparingly water-soluble compound is an organic solvent having a solubility of less than 10 % in water at a temperature of 20 °C and the hydrotrope agent is represented by the following general formula (II):

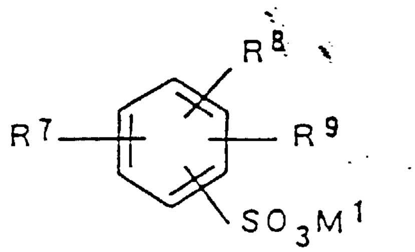

(II)

wherein $R^7$ to $R^9$ each independently represent a hydrogen atom, a $C_{1-4}$ alkyl group including straight-chain and branched alkyl group, a $C_{1-4}$ hydroxylalkyl group, a hydroxyl group, a halogen atom, a mercapto group or $-COOM^5$; $M^1$ and $M^5$ each represent a hydrogen atom, an alkaline metal or $NH_4$.

In the present invention, the lithographic printing plate is developed with an aqueous developer capable of peeling off substantially only the silicone rubber layer on the unexposed area. The image area is then dyed with a dye solution comprising at least one sparingly water-soluble compound and at least one hydrotrope agent as defined in claim 1. Thus, the sparingly water-soluble compound efficiently plasticizes the non-image area without giving any damage on the silicone rubber layer during dyeing, thereby improving the scratch resistance after processing and the press life during printing. The present invention will be further described hereinafter.

DETAILED DESCRIPTION OF THE INVENTION

The water-free lithographic printing plate according to the present invention must have a flexibility high enough to be set in an ordinary printing machine as well as withstand the load during printing. Accordingly, typical examples of the substrate include coated paper, metal plate such as aluminum plate, plastic film such as polyethylene terephthalate, rubber, and composite thereof.

In the present invention, a primer layer may be provided between the support and the photosensitive layer. As the primer layer to be used in the present invention there may be used various materials for the purpose of enhancing the adhesive property between the substrate and the photosensitive layer, inhibiting halation and improving the dyeability and printing properties of image. Examples of these materials include various photosensitive polymers which have been exposed and hardened before the lamination of a photosensitive resin layer as disclosed in JP-A-60-229031, thermoset epoxy resins as disclosed in JP-A-62-50760, hardened gelatin as disclosed in JP-A-63-133151, those comprising an urethane resin and a silane coupling agent as disclosed in JP-A-3-200965, and those comprising an urethane resin as disclosed in JP-A-3-273248. Besides these materials, hardened gelatin or casein is useful. Further, for the purpose of softening the primer layer, the foregoing primer layer may comprise a polymer having a glass transition temperature of not higher than room temperature such as polyurethane, polyamide, styrene/butadiene rubber, carboxy-modified styrene/butadiene rubber, acrylonitrile/butadiene rubber, carboxy-modified acrylonitrile/butadiene rubber, polyisoprene, acrylate rubber, polyethylene, chlorinated polyethylene and chlorinated polypropylene incorporated therein. The mixing ratio of such a polymer is arbitrary. The foregoing additive may be singly used to form a primer layer so far as a film layer can be formed. Moreover, for the foregoing purposes, the primer layer may also comprise additives such as dye, pH indicator, printing agent, photopolymerization initiator, adhesive aid (e.g., polymerizable monomer, diazo resin, silane coupling agent, titanate coupling agent, aluminum coupling agent), pigment and silica powder incorporated therein. Alternatively, a primer layer which has been coated may be exposed to light so that it is hardened. In general, the dry coating weight of the primer layer is preferably in the range of 0.1 to 20 $g/m^2$, more preferably 1 to 10 $g/m^2$.

As the photosensitive layer employable in the present invention there may be used e.g. a photopolymerizable photosensitive layer, a photocrosslinkable photosensitive layer or a photosensitive layer comprising a diazo resin, a binder resin.

The foregoing photopolymerizable photosensitive layer comprises (1) a monomer, oligomer or macromonomer having at least one photopolymerizable ethylenically unsaturated group, (2) a film-forming high molecular compound, and (3) a photopolymerization initiator.

Component (1): monomer, oligomer or macromonomer having at least one photopolymerizable ethylenically unsaturated group

Examples of the foregoing monomer, oligomer and macromonomer employable in the present invention include:

(A) Acrylic or methacrylic esters of alcohols (e.g., ethanol, propanol, hexanol, 2-ethylhexanol, cyclohexanol, glycerin, hexanediol, trimethylolpropane, pentaerythritol, sorbitol, triethylene glycol, polyethylene glycol, polypropylene glycol, ω-methoxypolyethylene glycol);
(B) Reaction product of amines (e.g., ethylamine, butylamine, benzylamine, ethylenediamine, hexamethylenediamine, diethylenetriamine, xylylenediamine, ethanolamine, aniline) with acrylic glycidyl, methacrylic glycidyl or allyl glycidyl;
(C) Reaction product of carboxylic acids (e.g., acetic acid, propionic acid, benzoic acid, acrylic acid, methacrylic acid, succinic acid, maleic acid, phthalic acid, tartaric acid, citric acid) with acrylic glycidyl, methacrylic glycidyl or allyl glycidyl; and
(D) Amide derivatives (e.g., acrylamide, N-methylolacrylamide, t-butylacrylamide, methylene bisacrylamide, diacetone acrylamide)

Other examples of the foregoing monomer, oligomer and macromonomer employable in the present invention include urethane acrylates as disclosed in JP-B-48-41708, JP-B-50-6034, and JP-A-51-37193, polyfunctional acrylates or methacrylates such as polyester acrylates and epoxy acrylates obtained by the reaction of epoxy resin with (meth) acrylic acid as disclosed in JP-A-48-64183, JP-B-43191, and JP-B-52-30490, and N-methylolacrylamide derivatives as disclosed in US-A-4,540,649. Further examples of the foregoing monomer, oligomer and macromonomer employable in the present invention include those described as photosetting monomers and oligomers in Nihon Settyakuzai Kyokai (Journal of Japan Adhesive Industry Association), Vol. 20, No. 7, pp. 300 308, 1984, and macromonomers as disclosed in P. Dreyfuss & R. P. Quirk, Encycl. Polym. Sci. Eng., 7, 551 (1987), Kagaku Kogyo (Chemical Industry), 38, 56 (1987), and Kobunshi Kako (Polymer Processing), 35, 262 (1986). However, the present invention is not limited to these compounds. In the polyfunctional monomers, various unsaturated groups such as acryl, methacryl, allyl and vinyl groups may be present in admixture. These compounds may be used singly or-in combination.

Useful examples of monomers employable in the present invention include:

$$CH_2{=}C(CH_3)COO(CH_2CH_2O)nCH_3$$

( n = 9, 14, 23)

$$CH_2{=}CHCOO(CH_2CH_2O)nCOCH{=}CH_2$$

(n = 4, 9, 14, 23)

$$CH_2{=}C(CH_3)COO(CH_2CH_2O)nCOC(CH_3){=}CH_2$$

(n = 4, 9, 14, 23)

$$CH_2{=}CHCOO(CH_2CH(CH_3)O)nCOCH{=}CH_2$$

(n = 4, 9, 14, 23)

$$\begin{array}{l} \quad\quad\quad\; CH_2O(CH_2CH_2O)_p COCH{=}CH_2 \\ \quad\quad\quad\;\; | \\ C_2H_5{-}CCH_2O(CH_2CH_2O)_q COCH{=}CH_2 \\ \quad\quad\quad\;\; | \\ \quad\quad\quad\; CH_2O(CH_2CH_2O)_r COCH{=}CH_2 \end{array}$$

(p+q+r=3、9、15、20)

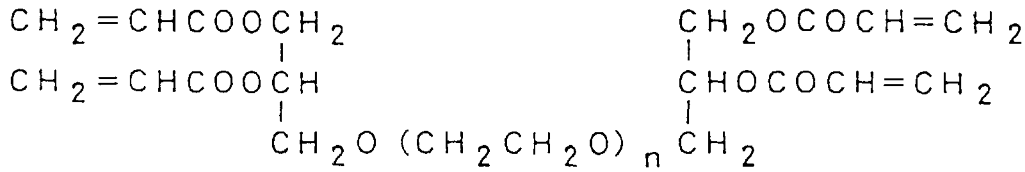

(n=9、14、18、23)

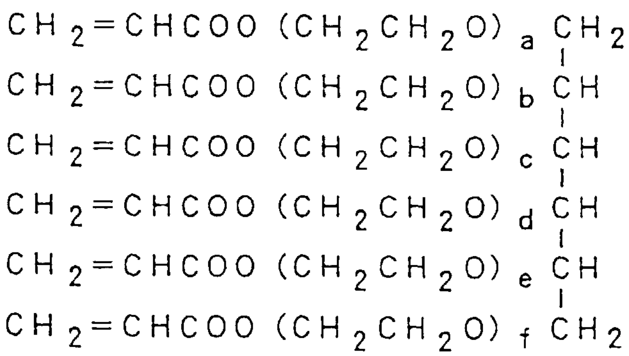

(a+b+c+d+e+f =30、40)

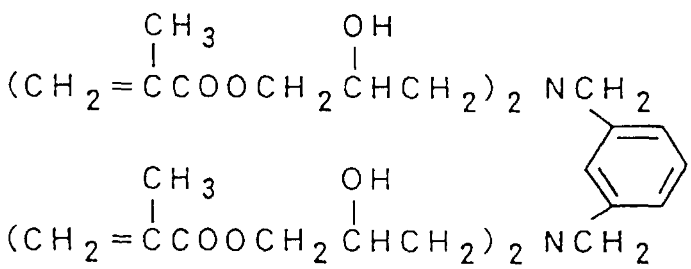

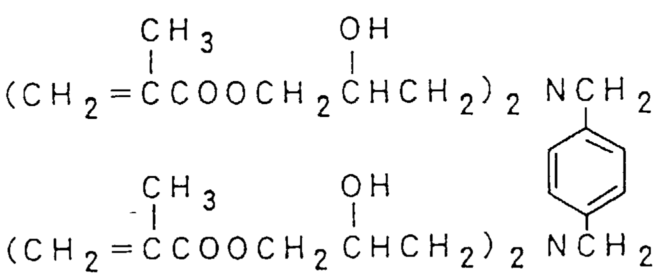

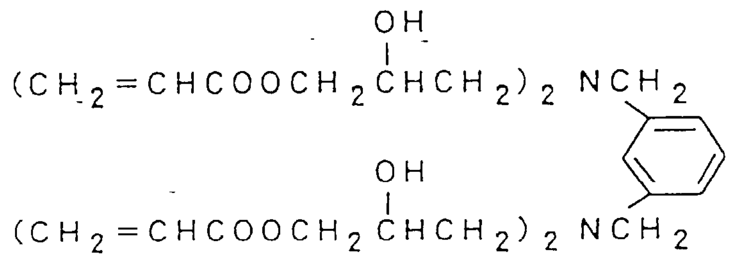

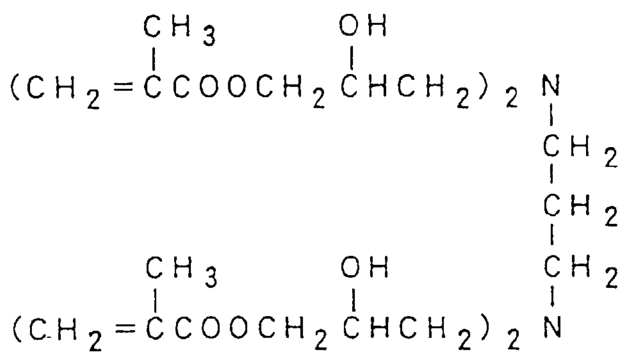

The amount of such a monomer to be used is in the range of 5 to 80 % by weight, preferably 30 to 70 % by weight based on the total solid content in the photopolymerizable photosensitive layer.

Component (2): Film-forming high molecular compound

Examples of the film-forming high molecular compound employable in the present invention include polyester resin, vinyl chloride-vinyl acetate copolymer, acrylic resin, vinyl chloride resin, polyamide resin, epoxy resin, (meth) acrylate copolymer, (meth)acrylamide copolymer, polyurethane resin, polyester urethane resin, vinyl acetate copolymer, polystyrene, phenoxy resin, acidic cellulose derivative, alcohol-soluble polyamide, (meth)acrylic acid copolymer, maleic acid copolymer, polyvinyl alcohol, water-soluble polyamide, water-soluble urethane, water-soluble cellulose, and polyvinyl pyrrolidone. Preferred among these film-forming high molecular compounds are polyurethane resins as disclosed in JP-A-2-236550, and JP-A-3-155553.

Further, as the film-forming high molecular compound there can be used a high molecular compound having a photopolymerizable or photocrosslinkable olefinically unsaturated double bonding group in its side chain. However, the present invention is not limited to these compounds.

The amount of such a film-forming high molecular compound to be added is in the range of 10 to 90 % by weight, preferably 25 to 75 % by weight based on the total weight of the photosensitive layer composition.

Component (3): Photopolymerization initiator

Typical examples of the photopolymerization initiator employable in the present invention include:

a) Benzophenone derivatives, e.g., benzophenone, Michler's ketone, xanthone, anthrone, thioxanthone, acridone, 2-chloroacridone, 2-chloro-N-n-butylacridone, 2,4-diethylthioxanthone, fluorenone;
b) Benzoin derivatives, e.g., benzoin, benzoin methyl ether, benzoin ethyl ether;
c) Quinones, e.g., p-benzoquinone, β-naphthoquinone, β-methylanthraquinone;
d) Sulfur compounds, e.g., dibenzyl disulfide, di-n-butyl disulfide;
e) Azo or diazo compounds, e.g., 2-azobisisobutyronitrile, 1-azobis-1-cyclohexanecarbonitrile, p-diazobenzylethylaniline, congo red;
f) Halogen compounds, e.g., carbon tetrachloride, silver bromide, α-chloromethylnaphthaline, trihalomethyl-s-triazine compound; and
g) Peroxides, e.g., benzoyl peroxide.

These photopolymerization initiators may be used singly or in combination. The amount of such a photopolymerization initiator to be added is in the range of 0.1 to 25 % by weight, preferably 3 to 20 % by weight based on the total weight of the photosensitive layer composition.

Other components:

Besides these components, a thermal polymerization inhibitor is preferably incorporated in the system. For example, hydroquinone, p-methoxyphenol, di-t-butyl-p-cresol, pyrogallol, t-butyl catechol, 4,4'-thiobis(3-methyl-6-t-butylphenol), 2,2'-methylenebis(4-methyl-6-t-butylphenol), and 2-mercaptobenzoimidazole are employable. If necessary, a dye or pigment may be incorporated in the system for the purpose of coloring the photosensitive layer. Further, a pH indicator or leuco dye may be incorporated in the system as a printing agent. Depending on the purpose, the photosensitive layer may further comprise a small amount of a silicone compound such as polydimethyl siloxane, methylstyrene-modified polydimethyl siloxane, olefin-modified polydimethyl siloxane, polyether-modified polydimethyl siloxane, silane coupling agent, silicon diacrylate and silicon dimethacrylate incorporated therein. In order to improve the coatability of the coating solution, the coating solution may comprise a siliconic surface active agent or fluorinic surface active agent incorporated therein. In order to improve the adhesive property between the photosensitive layer and the primer layer, the coating solution may further comprise a diazo resin incorporated therein. Further, the coating solution may comprise a plasticizer for rendering the coat flexible (e.g., polyethylene glycol, tricresyl phosphate) or a stabilizer (e.g., phosphoric acid) incorporated therein. The amount of these additives to be added is normally in the range of not more than 10 % by weight based on the total weight of the photosensitive layer composition. If necessary, a hydrophobic silica powder treated with a (meth)acryloyl- or allyl-containing silane coupling agent may be incorporated in the coating solution in an amount of not more than 50 % by weight based on the total weight of the photosensitive layer composition.

As the diazo resin which constitutes the photosensitive layer comprising a diazo resin and a binder resin there may be preferably used a condensate of an aromatic diazonium salt and formaldehyde. Particularly preferred examples of such a compound include a salt of p-diazodiphenylamine with formaldehyde or acetaldehyde, e.g., an inorganic salt of a diazo resin which is a reaction product of hexafluorophosphate, tetrafluoroborate, perchlorate or periodate with the foregoing condensate, and an organic salt of a diazo resin which is a reaction product of the foregoing condensate with a sulfonic acid as disclosed in US-A-3,200,309. The content of such a diazo resin in the photosensitive layer is preferably in the range of 20 to 95 % by weight, more preferably 35 to 80 % by weight.

As the binder resin there may be any kind of high molecular compound. Preferred examples of such a high molecular compound include a copolymer of a monomer having an aromatic hydroxyl group such as N-(4-hydroxyphenyl) acrylamide, N-(4-hydroxyphenyl)methacrylamide, o-, m- or p-hydroxystyrene and o-, m- or p-hydroxyphenyl methacrylate with other monomers as disclosed in JP-A-54-98613, a polymer containing a hydroxyethyl (meth)acrylate unit as a repeating unit as disclosed in US-A- 4,123,276, a copolymer resin comprising a monomer unit having a phenolic hydroxyl group and a monomer unit having an alcoholic hydroxyl group as disclosed in JP-A-3-158853, natural resin such as shellac and rosin, polyvinyl alcohol, a polyamide resin as disclosed in US-A- 3,751,257, linear polyurethane resin as disclosed in US-A- 3,660,097, a resin obtained by phthalating a polyvinyl alcohol, an epoxy resin obtained by the condensation of bisphenol A and epichlorohydrin, and cellulose such as cellulose butyrate and cellulose acetate.

Further, a compound comprising as a main component a photosensitive polymer such as polyester, polyamide and polycarbonate containing -CH=CH-CO- as a photosensitive group in its main or side chains may be used. Examples of such a compound include photosensitive polyester made of a condensate of phenylenediethyl acrylate with hydrogenated bisphenol A and triethylene glycol as disclosed in JP-A-55-40415, and photosensitive polyester derived from a (2-propenylidene)malonic compound such as cinnamylidenemalonic acid and a bifunctional glycol as disclosed in US-A-2,956,878.

The photosensitive layer comprising the foregoing diazo resin, too, may comprise e.g. a dye, a surface active agent, a plasticizer, a stabilizer, incorporated therein.

The foregoing photosensitive layer composition used in the present invention is coated onto the substrate in the form of solution in a proper solvent such as 2-methoxyethanol, 2-methoxyethyl acetate, propylene glycol methyl ethyl acetate, methyl lactate, ethyl lactate, propylene glycol monomethyl ether, ethanol, methyl ethyl ketone and N,N-dimethylacetamide, singly or in admixture. The dry coating weight of the photosensitive layer composition is preferably in the range of 0.1 to 20 $g/m^2$, more preferably 0.5 to 10 $g/m^2$.

The crosslinked silicone rubber layer to be used in the present invention is a film formed by hardening the following composition A or B:

| Composition A: | (parts by weight) |
|---|---|
| (a) Diorganopolysiloxane (number-average molecular weight: 3,000 to 40,000) | 100 |
| (b) Condensed crosslinking agent | 3 to 70 |
| (c) Catalyst | 0.01 to 40 |

The diorganosiloxane as the foregoing component (a) is a polymer having a repeating unit represented by the following general formula in which R and R' each represent a $C_{1-10}$ alkyl, vinyl or aryl group which may contain other suitable substituents. In general, 60 % or more of R and R' are preferably a methyl group or halogenated vinyl or phenyl group.

-Si(R)(R')O-

Such a diorganopolysiloxane is preferably terminated by a hydroxyl group at both ends thereof. The foregoing component (a) has a number-average molecular weight of 3,000 to 40,000, preferably 5,000 to 36,000.

The condensed crosslinking agent as the component (b) may be of any kind so far as it is condensed. It is preferably represented by the following general formula:

$$Rm{\cdot}Si{\cdot}Xn$$

(m + n = 4, with the proviso that n is not less than 2) wherein R is as defined above; and X represents a halogen atom such as chlorine, bromine and iodine, a hydrogen atom, a hydroxyl group or an organic substituent such as -O-COR, -OR, -O-N=$CR^3R^4$ and -$NR^5R^6$ (in which $R^3$, $R^4$, $R^5$ and $R^6$ each represent a $C_{1-10}$ alkyl group).

Examples of the catalyst as the component (c) include carboxylates of metal such as tin, zinc, lead, calcium and manganese (e.g., dibutyltin laurate, lead octylate and lead naphthenate), and known catalysts such as chloroplatinic acid.

| Composition B: | (parts by weight) |
|---|---|
| (d) Diorganopolysiloxane having addition-reactive functional group (number-average molecular weight: 3,000 to 40,000) | 100 |
| (e) Organohydrogen polysiloxane | 0.1 to 10 |
| (f) Addition catalyst | 0.00001 to 1 |

The diorganopolysiloxane having an addition-reactive functional group as the component (d) is an organopolysiloxane having at least two alkenyl groups (preferably vinyl groups) directly bonded to a silicon atom per molecule (number-average molecular weight: 3,000 to 40,000). The alkenyl group may be positioned either at the ends of the molecule or at the middle point in the molecule. Examples of organic groups other than alkenyl group include substituted or unsubstituted $C_{1-10}$ alkyl group and aryl group. The component (d) may optionally contain a slight amount of a hydroxyl group.

The component (d) has a number-average molecular weight of 3,000 to 40,000, preferably 5,000 to 36,000.

Examples of the component (e) include hydrogen both-terminated polydimethylsiloxane, $\alpha$, $\omega$-dimethylpolysiloxane, methyl both-terminated methylsiloxane-dimethylsiloxane copolymer, cyclic polymethylsiloxane, trimethylsilyl both-terminated both-terminated polymethylsiloxane, and trimethylsilyl dimethylsiloxane-methylsiloxane copolymer.

As the component (f) there may be arbitrarily selected from known compounds. In particular, platinum compounds are preferred. Examples of such platinum compounds include platinum, platinum chloride, chloroplatinic acid, and olefin-coordinated platinum. For the purpose of controlling the hardening rate of these compositions, a crosslinking inhibitor such as vinyl-containing organopolysiloxane (e.g., tetracyclo(methylvinyl)siloxane), carbon-carbon triple bond-containing alcohol, acetone, methyl ethyl ketone, methanol, ethanol and propylene glycol monomethyl ether may be incorporated therein.

The silicone rubber layer may comprise an adhesion aid or photopolymerization initiator such as finely divided powder of an inorganic substance (e.g., silica, calcium carbonate, titanium oxide), silane coupling agent, titanate coupling agent and aluminum coupling agent.

If the silicone rubber layer of the present invention has too small a thickness, it renders the printing plate less ink repellent and more liable to scratch. On the contrary, if the silicone rubber layer has too large a thickness, it deteriorates

the developability of the printing plate. Therefore, the thickness of the silicone rubber layer is preferably in the range of 0.5 to 5 g/m$^2$, more preferably 1 to 3 g/m$^2$.

In the water-free lithographic printing plate as defined herein, the silicone rubber layer may be further coated with various silicone rubber layers. For the purpose of enhancing the adhesive property between the photopolymerizable photosensitive layer and the silicone rubber layer or inhibiting the contamination of the catalyst in the silicone rubber layer, an adhesive layer may be provided between the photopolymerizable photosensitive layer and the silicone rubber layer.

In order to protect the surface of the silicone rubber layer, the silicone rubber layer may be laminated with a transparent film such as polyethylene, polypropylene, polyvinyl chloride, polyvinylidene chloride, polyvinyl alcohol, polyethylene terephthalate and cellophane or coated with a polymer. These films may be oriented before use. Further, these films may be matte-finished to improve the vacuum adhesion in the printing frame during imagewise exposure.

The water-free lithographic printing plate used in the present invention is exposed to light through a transparent original, and then developed with a developer capable of dissolving or swelling a part of the photosensitive layer on the image area (unexposed area).

As the developer employable in the present invention there may be used water or an aqueous solution of an organic solvent. Taking into account the safety and inflammability, the concentration of the water-soluble solvent is preferably less than 40 % by weight. Specific examples of the developer employable in the present invention include the following compounds:

Alcohols: e.g., methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, dipropylene glycol monomethyl ether, polyethylene glycol monomethyl ether, polypropylene glycol, tetraethylene glycol;
Ketones: e.g., acetone, methyl ethyl ketone;
Esters: e.g., ethyl acetate, methyl lactate, butyl lactate, propylene glycol monomethyl ether acetate, diethylene glycol acetate, diethyl phthalate;
Others: e.g., triethyl phosphate, tricresyl phosphate;
Mixture of the foregoing organic solvent with water; the foregoing organic solvent which has been solubilized in water with a surface active agent or the like;
Water: e.g., tap water, pure water, distilled water

The development may be carried out by a known method, e.g., by rubbing the surface of the lithographic printing plate with a development pad impregnated with a developer as mentioned above or rubbing the surface of the lithographic printing plate with a development brush while the developer being poured thereonto or thereafter. The developer temperature may be arbitrary but is preferably in the range of 10 °C to 50 °C. In this manner, only the silicone rubber layer on the unexposed area is removed, rendering the area ink-receptive.

The printing plate thus obtained may be dyed with a dye solution on the exposed image area so that the image area can be detected to confirm its image forming properties. The image area may be lightly rubbed with a soft pad impregnated with a dye solution to cause only the exposed image area on the photosensitive layer to be dyed, making it possible to confirm that development has been made up to highlight area.

The dye solution to be used in the process for the preparation of the water-free lithographic printing plate according to the present invention is a dye solution for water-free lithographic printing plate containing at least one sparingly water-soluble compound and at least one hydrotrope agent as defined in claim 1. The sparingly water-soluble compound to be contained in the dye solution used in the present invention is an organic solvent having a solubility of less than 10 % in water at a temperature of 20 °C. Specific examples of such an organic solvent include diisobutyl ketone, acetophenone, isophorone, diethyl succinate, methyl benzoate, diethyl oxalate, dimethyl phthalate, isobutyl acetate, benzyl benzoate, ethylene glycol monophenyl ether, ethylene glycol dibutyl ether, ethylene glycol benzyl ether, diethylene glycol monohexyl ether, diethylene glycol dibutyl ether, dimethyl benzyl carbitol, diethylene glycol diacetate, 2-ethylhexyl alcohol, benzyl alcohol, cyclohexanol, 1,3-octanediol, cyclohexanone, N-benzylethanolamine, anisyl alcohol, 2-N-ethylanilinoethanol, N-phenylethanolamine, triacetin, tributin, propylene glycol monophenyl ether, and compounds represented by the following formula (I) (e.g., dipropylene glycol monohexyl ether, tripropylene glycol monobutyl ether, polypropylene glycol monopropyl ether (MW=400)). The present invention is not limited to these compounds.

$$R^1O\text{-}(C_3H_6O)_n\text{-}R^2 \qquad (I)$$

In the formula $R^1$ represents a substituted or unsubstituted alkyl group, a substituted or unsubstituted aryl group,

a substituted or unsubstituted aralkyl group or a substituted or unsubstituted alkenyl group; $R^2$ represents a hydrogen atom, an alkyl group, an aryl group, an aralkyl group or an alkenyl group; and n represents an integer of 2 or more.

Preferred among these compounds are the compounds represented by the formula (I), ethylene glycol monophenyl ether, diethylene glycol monohexyl ether, benzyl alcohol, 1,3-octanediol, cyclohexanone, N-phenylethanolamine, triacetin, and propylene glycol monophenyl ether.

The specific examples of the substituents for the substituted groups represented by $R^1$ include a halogen atom, a hydroxyl group, an alkoxy group, a phenyl group, a nitro group and a cyano group. In formula (I), the groups $R^1$ and $R^2$ are preferably those containing hydrocarbons having 2 to 12 carbon atoms.

The concentration of such a compound in the dye solution is preferably in the range of 0.1 to 80 % by weight, more preferably 2 to 60 % by weight, most preferably 5 to 40 % by weight.

The hydrotrope agent to be used in the present invention is represented by the following general formula (II) :

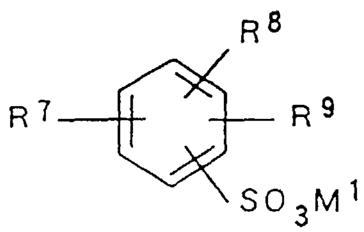

(II)

In this general formula, $R^7$ to $R^9$ each independently represent a hydrogen atom, a $C_{1-4}$ alkyl group (including straight-chain and branched alkyl group), a $C_{1-4}$ hydroxylalkyl group, a hydroxyl group, a halogen atom (e.g., chlorine, bromine), a mercapto group or $-COOM^5$.

$M^1$ and $M^5$ each represent a hydrogen atom, an alkaline metal (e.g., Na, K) or $NH_4$.

Specific examples of the compounds represented by formula (II) to be used in the present invention include benzenesulfonic acid, p-toluenesulfonic acid, xylenesulfonic acid, cumensulfonic acid, isophthalylsulfonic acid and phenolsulfonic acid. Further, alkaline metal (e.g., Na, K, Li) salts and ammonium salts of these compounds may be used.

Particularly preferred examples of the hydrotrope agent employable in the present invention include sodium p-toluenesulfonate, sodium metaxylenesulfonate, sodium p-ethylbenzenesulfonate, sodium cumensulfonate and ammonium xylenesulfonate. The present invention is not limited to these compounds. Preferred among these compounds are sodium p-toluenesulfonate, sodium metaxylenesulfonate and ethylbenzenesulfonate.

The concentration of the hydrotrope agent in the dye solution is preferably in the range of 0.05 to 50 %, more preferably 0.5 to 30 %.

The dye to be contained in the dye solution of the present invention may be selected from the group consisting of water-soluble disperse dye, acidic dye, and basic dye. Particularly preferred among these dyes are triarylmethane acidic dyesand triarylmethane basic dyes. Specific examples of these acidic dyes include ACID VIOLET 5B (available from Hodogaya Chemical Co., Ltd.), KITON BLUE A (available from CIBA), PATENT BLUE AF (available from BASF), RAKUTO BRILLIANT BLUE FCF (available from Rakuto Chemical Industries, Ltd.), BRILLIANT ACID BLUE R (available from GEIGY), KAYANOL CYANINE 6B (available from Nippon Kayaku Co., Ltd.), SUPRANOL CYANINE G (available from FARBENFABRIKEN BAYER), ORIENT SOLUBLE BLUE OBB (available from Orient Chemical Industries, Ltd.), ACID BRILLIANT BLUE 5G (available from Chugai Chemical), ACID BRILLIANT BLUE FFR (available from Chugai Chemical), ACID GREEN GBH (available from Takaoka Chemical Industries, Ltd.), and ACID BRILLIANT MILLING GREEN B (available from Hodogaya Chemical Co., Ltd.). Specific examples of basic dyes include crystal violet, ethyl violet, victoria pure blue, victoria blue, methyl violet, DIABASIC MAGENTA (available from Mitsubishi Kagaku), AIZENE BASIC CYANINE 6GH (available from Hodogaya Chemical Co., Ltd.), PRIMOCYANINE BX CONC. (Sumitomo Chemical Co., Ltd.), ASTRAZON BLUE G (available from FABENFABRIKEN BAYER), DIACRYL SUPRA BRILLIANT 2B (Mitsubishi Kagaku), AIZEN CATHILON TURQUOISE BLUE LH (available from Hodogaya Chemical Co., Ltd.), AIZEN DIAMOND GREEN GH (available from Hodogaya Chemical Co., Ltd.), and AIZEN MALACHITE GREEN (available from Hodogaya Chemical Co., Ltd.). Particularly preferred among these dyes are crystal violet, ethyl violet, and victoria pure blue. The concentration of the dye in the dye solution is preferably in the range of 0.01 to 10 % by weight, more preferably 0.05 to 5 % by weight.

In the present invention, the dye solution may comprise a surface active agent and an organic solution having a solubility of not less than 10 % by weight in water at a temperature of 20 °C incorporated therein to improve the stability thereof. As such a surface active agent there may be used a commonly used known surface active agent. Anionic surface active agents and nonionic surface active agents are preferred. Examples of anionic surface active agents include sulfuric esters of high alcohols ($C_8$ - $C_{22}$) (e.g., sodium salt of laurylalcohol sulfate, sodium salt of octylalcohol

sulfate, ammonium salt of laurylalcohol sulfate), phosphoric esters of aliphatic alcohols (e.g., sodium salt of phosphoric ester of cetylalcohol), $C_{8-22}$ alkylsulfonates (e.g., sodium salt of octylsulfonic acid, sodium salt of dodecylsulfonic acid), $C_{12-30}$ alkylaurylsulfonates (e.g., sodium salt of dodecylbenzenesulfonic acid, sodium salt of dinaphthalenedisulfonic acid), $C_{8-22}$ aliphatic carboxylates (e.g., sodium salt of stearate, sodium salt of oleic acid), sulfonates of alkylamide (e.g., methyloleyl ureide), and sulfonates of dibasic aliphatic ester (e.g., dioctylester sodiumsuccinate, dihexyl sodiumsulfosuccinate). The present invention is not limited to these compounds. Examples of nonionic surface active agents include polyethylene glycol, polyoxyethylene lauryl ether, polyoxyethylene nonyl ether, polyoxyethylene stearyl ether, polyoxyethylene behenyl ether, polyoxyethylene polyoxypropylene cetyl ether, polyoxyethylene polyoxypropylene behenyl ether, polyoxyethylene phenyl ether, oxyethylene oxypropylene block polymer, tribenzylphenolpolyethylene oxide adduct, and octylphenolpolyoxyethyleneoxypropylene adduct. The present invention is not limited to these compounds.

The concentration of such a surface active agent in the dye solution is preferably in the range of 0.1 to 30 % by weight, more preferably 1 to 20 % by weight.

Specific examples of the organic solvent having a solubility of not less than 10 % by weight in water at a temperature of 20 °C include alcohols (e.g., methanol, ethanol, isopropanol, 2-ethylhexanol, tetrahydrofurfurylalcohol), ethers (e.g., 1,4-dioxane, tetrahydrofuran), ketones (e.g., methyl ethyl ketone, acetonyl acetone, diacetone alcohol), esters (e.g., methyl formate, methyl acetate, methyl lactate, ethyl lactate), polyvalent alcohols and derivatives thereof (e.g., ethylene glycol, ethylene glycol monomethyl ether, ethylene glycol monomethyl ether acetate, ethylene glycol diethyl ether, methoxy methoxy ethanol, diethylene glycol monoethyl ether, diethylene glycol monoethyl ether acetate, diethylene glycol monobutyl ether, diethylene glycol methyl ethyl ether, triethylene glycol, triethylene glycol monomethyl ether, propylene glycol, propylene glycol monomethyl ether, butanediol, trimethylol propane, 1,2,6-hexanetriol), nitrogen compounds (e.g., methylamine, dimethylamine, trimethylamine, triethylamine, isopropylamine, cyclohexylamine, triethanolamine, acetamide, acetonitrile, quinoline, morpholine), and acids (e.g., formic acid, acetic acid, butyric acid, caproic acid, cyclopropanecarboxylic acid, benzoic acid, 2-aminopropanic acid, succinic acid, phthalic acid, maleic acid, fumaric acid, tartaric acid, malic acid, oxalic acid, acetacetic acid, malonic acid, citric acid). The present invention is not limited to those compounds.

The concentration of such an organic acid having a water solubility of not less than 10 % by weight at 20 °C in the dye solution is preferably in the range of 0.5 to 30 % by weight, more preferably 1 to 20 % by weight.

Further, the dye solution used in the present invention may comprise an anti-foam fluid, a chelating agent, and an antiseptic incorporated therein.

The dye solution used in the present invention can be prepared by dissolving the foregoing components in water. The content of water in the dye solution is preferably in the range of 1 to 99 % by weight, more preferably 40 to 90 % by weight.

In the dyeing process, the water-free lithographic printing plate is dipped in the dye solution. For the purpose of inhibiting the occurrence of dye spot, the surface of the printing plate may be rubbed with a brush or the like. In this process, the area which has been underdeveloped in the development process can be further developed.

In the process for the preparation of the water-free lithographic printing plate according to the present invention, the surface of the printing plate is preferably washed with tap water after dyeing or development. Further, the printing plate which has been rinsed is preferably dried with hot air of 40 °C to 100 °C.

If the process for the preparation of the water-free lithographic printing plate according to the present invention is effected in an automatic developing machine, all the processing solutions are preferably kept at predetermined temperatures by means of a temperature controlling mechanism. The temperature of all the processing solutions are normally controlled to a range of 15 °C to 60 °C by means of a heater interlocked with a temperature sensor. If the developer is tap water, the developer can be discharged from an overflow mechanism by supplying tap water through a faucet directly connected to the automatic developing machine so that the developer can be prevented from being decomposed or sludge from the development of silicone rubber can be discharged. For the rinsing water also, tap water can be similarly supplied to inhibit the decomposition thereof.

Examples of the process in which a faucet and an automatic developing machine are directly connected to each other to supply tap water into the automatic developing machine include a process in which tap water is supplied into the automatic developing machine by opening or closing a faucet, and a process in which tap water is supplied into the automatic developing machine upon the passage of the printing plate or at a predetermined time interval by means of a solenoid valve operative interlocked with a plate sensor or microcomputer. All the processing solutions are preferably automatically replenished by means of a feed system operative interlocked with a liquid level sensor or microcomputer. In this case, the composition of the replenishers may be the same or different from that of the processing solutions.

For example, the relationship between the concentration ($C_1$) of any component in the dye solution and the concentration ($C_2$) of the same component in the replenisher is quite arbitrary but is often represented by $10 \geq C_2/C_1 \geq 0$. Components which are not contained in the original dye solution may be contained in the replenisher. Examples of such components include anti-foam fluid, chelating agent, antiseptic, dye, solvent, and surface active agent.

The water-free lithographic printing plate is imagewise exposed to light from an ultraviolet lamp with an original film kept in contact therewith or imagewise exposed to scanning laser light. The printing plate thus exposed is then developed and dyed in accordance with the plate-making process. Prior to development and dyeing, the printing plate may be subjected to heat treatment so that it is sensitized. The procedures from exposure to development can be automatically carried out by an automatic conveyance mechanism to provide a remarked improvement in operating efficiency. Such a system is particularly useful in the exposure of a water-free lithographic printing plate to scanning laser.

In accordance with the processing method according to the present invention, the non-image area can be efficiently plasticized without damaging the silicone rubber layer during processing, thereby improving the scratch resistance in handling and the press life during printing.

The present invention will be further described in the following examples, but the present invention should not be construed as being limited thereto. Unless otherwise indicated, all the parts are by weight.

EXAMPLE 1

(Primer layer)

A 0.3-mm thick JIS A 1050 aluminum plate which had been degreased by an ordinary method was dipped in a 1 wt.% aqueous solution of KBM613 (available from Shin-etsu Chemical Co., Ltd.) as an aminosilane coupling agent, and then dried at room temperature. A primer coating solution having the following composition was coated onto the aluminum plate in a dry weight of 4 g/m$^2$, and then heated to a temperature of 140 °C for 2 minutes so that it was dried.

| | |
|---|---|
| Sanprene IB1700D (available from Sanyo Chemical Industries, Ltd.) | 10 parts |
| Hexafluorophosphate of condensation polymer of p-diazophenylamine and paraformaldehyde | 0.1 part |
| $TiO_2$ | 0.1 part |
| DEFENSA MCF323 (available from Dainippon Ink and Chemicals, Inc.) | 0.03 part |
| Propylene glycol methyl ether acetate | 50 parts |
| Methyl lactate | 20 parts |
| Pure water | 1 part |

The coated material was then subjected to exposure for 20 counts by means of a vacuum exposure machine FT261V UDNS ULTRA-PLUS FLIPTOP PLATE MAKER available from NUARC COMPANY, INC.

(Photosensitive layer)

Onto the primer-coated aluminum plate was coated a photopolymerizable photosensitive layer coating solution having the following composition in a dry weight of 4 g/m$^2$. The coated material was then dried at a temperature of 100 °C for 1 minute.

| | |
|---|---|
| Polyurethane resin (isophorone diisocyanate/polyester (adipic acid/1,6-butanediol /ethylene glycol)/ 2,2-dimethylpropane-1,3-diol/isophoronediamine) | 1.5 parts |
| A-600 (polyethylene glycol diacrylate available from Shinnakamura Chemical Co., Ltd.) | 0.5 part |
| Adduct of 1 mol of xylylenediamine and 4 mols of glycidyl dimethacrylate | 1.0 part |
| Michler's ketone of ethyl | 0.35 part |
| 2-Chlorothioxanthone | 0.10 part |
| Naphthalenesulfonate of victoria pure blue BOH | 0.01 part |
| DEFENSA MCF323 (available from Dainippon Ink & Chemicals, Inc.) | 0.03 part |
| Methyl ethyl ketone | 10 parts |
| Propylene glycol methyl ether | 25 parts |

(Ink-repelling layer)

Onto the foregoing photopolymerizable photosensitive layer was coated a silicone rubber layer coating solution having the following composition in a dry weight of 2 g/m$^2$. The coated material was then dried at a temperature of 140 °C for 2 minutes.

| | |
|---|---|
| α, ω-Divinylpolysiloxane (polymerization degree: about 700) | 9 parts |
| $(CH_3)_3SiO(SiH(CH_3)O)_8Si(CH_3)_3$ | 0.4 part |
| Polydimethyl siloxane (polymerization degree: 8,000) | 0.3 part |
| Olefin-chloroplatinic acid | 0.2 part |
| $HC{\equiv}CC(CH_3)_2OSi(CH_3)_3$ | 0.1 part |
| Isoper G (available from Esso Chemical Co., Ltd.) | 140 parts |

Onto the surface of the silicone rubber layer thus obtained was laminated a 6-µm thick single-matted polyethylene terephthalate film in such an arrangement that the unmatted side of the film comes in contact with the silicone rubber layer to obtain a water-free lithographic printing plate.

Onto the printing plate was laminated a gray scale (G/S) having an optical density difference of 0.15. The laminate was then exposed to light for 30 counts by means of a vacuum exposure machine FT261V UDNS ULTRA-PLUS FLIPTOP PLATE MAKER manufactured by NUARC COMPANY, INC. The laminate film was then peeled off. The surface of the printing plate was rubbed with a pad impregnated with tap water to remove the silicone rubber layer from the image area. The surface of the printing plate was then lightly wiped with a pad impregnated with a dye solution set forth in Table 1 for 30 seconds so that the image area from which the silicone rubber layer had been removed was dyed. The dye density of the image area was measured by a Macbeth reflection densitometer (visual mode).

TABLE 1

| Component | | |
|---|---|---|
| Example 1 | Tripropylene glycol monobutyl ether<br>Sodium 4-metaxylenesulfonate<br>Water | 12 parts<br>16 parts<br>72 parts |
| Example 2 | Tripropylene glycol monopropyl ether<br>Sodium p-toluenesulfonate<br>Water | 9 parts<br>12 parts<br>79 parts |
| Example 3 | Triacetin<br>p-Ethylbenzenesulfonic acid<br>Water | 10 parts<br>10 parts<br>80 parts |
| Example 4 | Diethylene glycol monohexyl ether<br>Sodium p-ethylbenzenesulfonate<br>Water | 15 parts<br>10 parts<br>75 parts |
| Comparative Example 1 | Diethylene glycol monoethyl ether<br>Water | 10 parts<br>90 parts |
| Comparative Example 2 | Diethylene glycol monohexyl ether<br>Newcol B4SN (Nihon Nyukazai K.K.)<br>Water | 15 parts<br>20 parts<br>65 parts |
| Comparative Example 3 | Benzyl alcohol<br>Noigen HC (Daiichi Kogyo Seiyaku Co., Ltd.)<br>Water | 10 parts<br>15 parts<br>75 parts |

* These examples and comparative examples each contain ethyl violet (available from Hodogaya Chemical Co., Ltd.) in an amount of 0.4 parts.

The non-image area on the water-free lithographic printing plate thus obtained was evaluated for the scratch resistance of the silicone rubber layer by means of HEIDON (available from Shinto Chemical) with a 0.25-mm dia. sapphire stylus under a load of 100 g. The water-free lithographic printing plate was evaluated for press life (number of sheets reached until the occurrence of spot stains on the non-image area due to paper dust is printable number of sheets) when printed with AQUALESS G black ink TOYO KING ULTRA TUK available from Toyo Ink by means of Hiderberg GTO printing machine from which a dampening system had been removed. The results are set forth in Table 2. Table

2 shows that the processing method according to the present invention can provide improvements in the scratch resistance and press life of water-free lithographic printing plate.

TABLE 2

| | Dye Density | Scratch Resistance | Press Life (printable number of sheets) |
|---|---|---|---|
| Example 1 | 1.38 | good | 100,000 sheets or more |
| Example 2 | 1.31 | " | " |
| Example 3 | 1.27 | " | " |
| Example 4 | 1.34 | " | " |
| Comparative Example 1 | 1.05 | bad | 60,000 sheets |
| Comparative Example 2 | 1.29 | " | 80,000 sheets |
| Comparative Example 3 | 1.31 | " | " |

Scratch resistance:

good: No ink attachment to scratched area during printing
bad: Ink attachment to scratched area during printing

## Claims

1. A process for processing a photosensitive lithographic printing plate requiring no fountain solution comprising a photosensitive layer and a silicone rubber layer laminated on a support in this order, said process comprising the steps of:

   (a) imagewise exposing said lithographic printing plate;

   (b) developing the exposed lithographic printing plate with an aqueous developer capable of peeling off substantially only the silicone rubber layer on the unexposed area; and then

   (c) dyeing the exposed image area with a dye solution comprising at least one sparingly water-soluble compound and at least one hydrotrope agent, wherein the sparingly water-soluble compound is an organic solvent having a solubility of less than 10 % in water at a temperature of 20 °C and the hydrotrope agent is represented by the following general formula (II):

   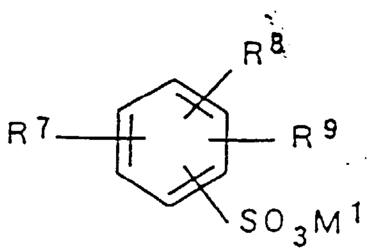

   (II)

   wherein $R^7$ to $R^9$ each independently represent a hydrogen atom, a $C_{1-4}$ alkyl group including straight-chain and branched alkyl group, a $C_{1-4}$ hydroxylalkyl group, a hydroxyl group, a halogen atom, a mercapto group or $-COOM^5$; $M^1$ and $M^5$ each represent a hydrogen atom, an alkaline metal or $NH_4$.

## Patentansprüche

1. Verfahren zur Behandlung einer photosensitiven, keine Sprühwasserlösung erfordernden Flachdruckplatte, die eine photosensitive Schicht und eine Silikongummischicht, in dieser Reihenfolge auf einen Träger laminiert, umfaßt, wobei das Verfahren die Schritte aufweist:

(a) bildweises Belichten der Flachdruckplatte;

(b) Entwickeln der belichteten Flachdruckplatte mit einem wässerigen Entwickler, der in der Lage ist, im wesentlichen nur die Silikongummischicht im unbelichteten Bereich abzulösen und dann

(c) Anfärben des belichteten Bildbereichs mit einer Farbstofflösung, die mindestens eine kaum wasserlösliche Verbindung und mindestens ein hydrotropes Agens umfaßt, in der die kaum wasserlösliche Verbindung ein organisches Lösungsmittel mit einer Löslichkeit von weniger als 10% in Wasser bei einer Temperatur von 20°C ist, und das hydrotrope Agens durch die nachfolgende allgemeine Formel (II) dargestellt ist:

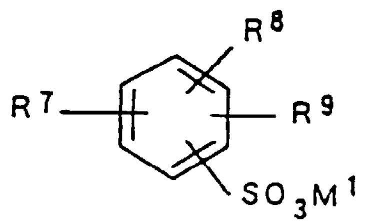

(II)

in der jedes $R^7$ bis $R^9$ unabhängig ein Wasserstoffatom, eine $C_{1-4}$-Alkylgruppe, einschließlich geradkettiger und verzweigter Alkylgruppen, eine $C_{1-4}$-Hydroxyalkylgruppe, eine Hydroxylgruppe, ein Halogenatom, eine Mercaptogruppe oder $-COOM^5$ ist; jedes $M^1$ und $M^5$ ein Wasserstoffatom, ein Alkalimetall oder $NH_4$ darstellt.

## Revendications

**1.** Procédé de traitement d'une plaque d'impression lithographique photosensible ne nécessitant pas de solution de mouillage comprenant une couche photosensible et une couche de caoutchouc de silicone stratifiée sur un support dans cet ordre, ledit procédé comprenant les étapes de :

(a) exposer pour former une image de ladite plaque d'impression lithographique ;
(b) développer la plaque d'impression lithographique exposée avec un développateur aqueux capable de décoller sensiblement seulement la couche de caoutchouc de silicone sur les zones non exposées ; et
(c) colorer la zone d'image exposée avec une solution de colorant comprenant au moins un composé peu soluble dans l'eau et au moins un agent hydrotrope, où le composé peu soluble dans l'eau est un solvant organique ayant une solubilité inférieure à 10% dans l'eau à une température de 20°C et l'agent hydrotrope est représenté par la formule générale suivante (II) :

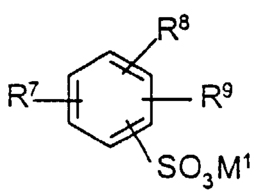

(II)

où $R^7$ à $R^9$ représentent chacun indépendamment un atome d'hydrogène, un groupe alkyle $C_1$-$C_4$ comprenant une chaîne droite et un groupe alkyle ramifié, un groupe hydroxyalkyle $C_1$-$C_4$, un groupe hydroxyle, un atome d'halogène, un groupe mercapto ou $-COOM^5$ ; $M^1$ et $M^5$ représentent chacun un atome d'hydrogène, un métal alcalin ou $NH_4$.